# EUROPEAN PATENT SPECIFICATION

(11) **EP 3 614 432 B1**
(45) Date of publication and mention of the grant of the patent: **26.11.2025**
(21) Application number: 19192596.5
(22) Date of filing: 20.08.2019
(51) Int. Cl.: H10D 30/67, H10D 86/40, H10D 86/60

(54) **METHOD OF MANUFACTURING DISPLAY DEVICE**
VERFAHREN ZUR HERSTELLUNG EINER ANZEIGEVORRICHTUNG
PROCÉDÉ DE FABRICATION D'UN AFFICHEUR

(30) Priority: 23.08.2018 KR 20180098808
(43) Date of publication of application: 26.02.2020
(73) Proprietor: Samsung Display Co., Ltd., Yongin-si, Gyeonggi-do 17113 (KR)
(72) Inventor: CHO, Yoon-Jong, Gyeonggi-do (KR); KWON, Semyung, Gyeonggi-do (KR); PARK, Ji Yong, Gyeonggi-do (KR); SEONG, Seok Je, Gyeonggi-do (KR)
(74) Representative: Walaski, Jan Filip

(56) References cited:
- US-A1- 2011 278 564
- US-A1- 2011 304 311
- US-A1- 2018 040 640
- US-A1- 2018 061 867

## Description

Exemplary embodiments of the invention relate generally to a display device and, more specifically, to an organic light-emitting display device and a method of manufacturing the same.

An organic light-emitting display device is capable of emitting light to display an image. With advantages of an organic light-emitting display device, such as light weight and thin thickness, characteristics of which are particularly useful for a flexible display device, the usage of the organic light-emitting display device is increasing.

In order to effectively drive an organic light-emitting diode, an organic light-emitting display device including both a silicon-based semiconductor element and an oxide-based semiconductor element is recently being developed.

The above information is only for understanding of the background of the inventive concepts, and, therefore, it may contain information that does not constitute prior art.

US 2018/0040640 discloses a display device.

Exemplary embodiments of the invention provide a method of manufacturing a display device with improved reliability.

Additional features of the inventive concepts will be set forth in the description which follows, and in part will be apparent from the description, or may be learned by practice of the inventive concepts.

According to of the invention, there is provided a method of manufacturing a display device as set out in claim 1.

A display device manufactured according to an exemplary embodiment includes a first active pattern including a silicon semiconductor, a first insulation layer covering the first active pattern, a first gate electrode disposed on the first insulation layer, a second insulation layer covering the first gate electrode, a gate wiring pattern disposed on the second insulation layer, a third insulation layer covering the gate wiring pattern, and a second active pattern disposed on the third insulation layer and including an oxide semiconductor. The gate wiring pattern includes a lower layer and an upper layer. The lower layer includes titanium or titanium alloy, and the upper layer includes molybdenum or molybdenum alloy.

A thickness of the lower layer may be about 50 Å (5nm) to about 300 Å (30nm), and a thickness of the upper layer may be about 2,000 Å (200nm) to about 2,500 Å (250nm).

The lower layer may include titanium, and the upper layer may include molybdenum.

The third insulation layer may include a lower barrier layer including silicon nitride, and an upper barrier layer disposed on the lower barrier layer and including silicon oxide.

A thickness of the lower barrier layer may be about 200 Å (20nm) to about 1,000 Å (100nm), and a thickness of the upper barrier layer may be about 1,000 Å (100nm) to about 3,000 Å (300nm).

The display device further includes a bottom gate electrode disposed between the second insulation layer and the third insulation layer and overlapping the second active pattern.

The bottom gate electrode includes a lower layer including titanium or titanium alloy, and an upper layer including molybdenum or molybdenum alloy.

The display device may further include a top gate electrode disposed on the second active pattern.

The display device may further include an organic light-emitting diode electrically connected to the first active pattern.

A method for manufacturing a display device according to an exemplary embodiment includes the steps of forming a first active pattern including a silicon semiconductor; forming a first gate electrode on the first active pattern; forming a second insulation layer to cover the first gate electrode; forming a gate metal layer on the second insulation layer, in which the gate metal layer includes a lower layer including titanium or titanium alloy, and an upper layer including molybdenum or molybdenum alloy; etching the upper layer by using a first etching gas including fluorine; etching the lower layer by using a second etching gas different from the first etching gas to form a gate metal pattern including a bottom gate electrode; forming a third insulation layer on the gate metal pattern; and forming a second active pattern including an oxide semiconductor and overlapping the bottom gate electrode on the third insulation layer.

It is to be understood that both the foregoing general description and the following detailed description are exemplary and explanatory and are intended to provide further explanation of the invention as claimed.

The accompanying drawings, which are included to provide a further understanding of the invention and are incorporated in and constitute a part of this specification, illustrate exemplary embodiments of the invention, and together with the description serve to explain the inventive concepts.
FIGS. 1, 2, 3, 4, 5, 6, 7, 8, 9, 10, and 11 are cross-sectional views illustrating a method for manufacturing an organic light-emitting display device according to an exemplary embodiment.
FIG. 12 is a cross-sectional view of an organic light-emitting display device according to an exemplary embodiment.
FIGS. 13, 14, 15, and 16 are cross-sectional views illustrating a method for manufacturing an organic light-emitting display device according to an exemplary embodiment.
FIG. 17 is a cross-sectional view of an organic light-emitting display device fabricated in accordance with the claimed invention.
FIG. 18 is a cross-sectional view of an organic light-emitting display device according to an exemplary embodiment.

In the following description, for the purposes of explanation, numerous specific details are set forth in order to provide a thorough understanding of various exemplary embodiments or implementations of the invention. As used herein "embodiments" and "implementations" are interchangeable words that are non-limiting examples of devices or methods employing one or more of the inventive concepts disclosed herein. It is apparent, however, that various exemplary embodiments may be practiced without these specific details or with one or more equivalent arrangements. In other instances, well-known structures and devices are shown in block diagram form in order to avoid unnecessarily obscuring various exemplary embodiments. Further, various exemplary embodiments may be different, but do not have to be exclusive. For example, specific shapes, configurations, and characteristics of an exemplary embodiment may be used or implemented in another exemplary embodiment without departing from the inventive concepts.

Unless otherwise specified, the illustrated exemplary embodiments are to be understood as providing exemplary features of varying detail of some ways in which the inventive concepts may be implemented in practice. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an exemplary embodiment may be implemented differently, a specific process order may be performed differently from the described order. For example, two consecutively described processes may be performed substantially at the same time or performed in an order opposite to the described order. Also, like reference numerals denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the D1-axis, the D2-axis, and the D3-axis are not limited to three axes of a rectangular coordinate system, such as the x, y, and z - axes, and may be interpreted in a broader sense. For example, the D1-axis, the D2-axis, and the D3-axis may be perpendicular to one another, or may represent different directions that are not perpendicular to one another. For the purposes of this disclosure, "at least one of X, Y, and Z" and "at least one selected from the group consisting of X, Y, and Z" may be construed as X only, Y only, Z only, or any combination of two or more of X, Y, and Z, such as, for instance, XYZ, XYY, YZ, and ZZ. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the exemplary term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various exemplary embodiments are described herein with reference to sectional and/or exploded illustrations that are schematic illustrations of idealized exemplary embodiments and/or intermediate structures. As such, variations from the shapes of the illustrations as a result, for example, of manufacturing techniques and/or tolerances, are to be expected. Thus, exemplary embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined, all terms (including technical and scientific terms) used herein have the same meaning as commonly understood by one of ordinary skill in the art to which this disclosure is a part. Terms, such as those defined in commonly used dictionaries, should be interpreted as having a meaning that is consistent with their meaning in the context of the relevant art and should not be interpreted in an idealized or overly formal sense, unless expressly so defined herein.

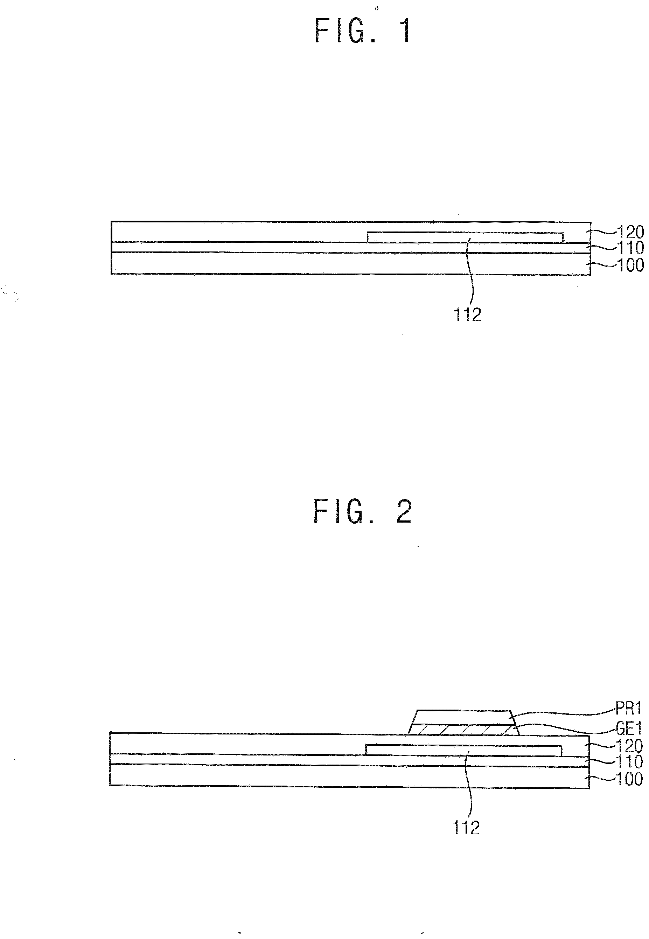

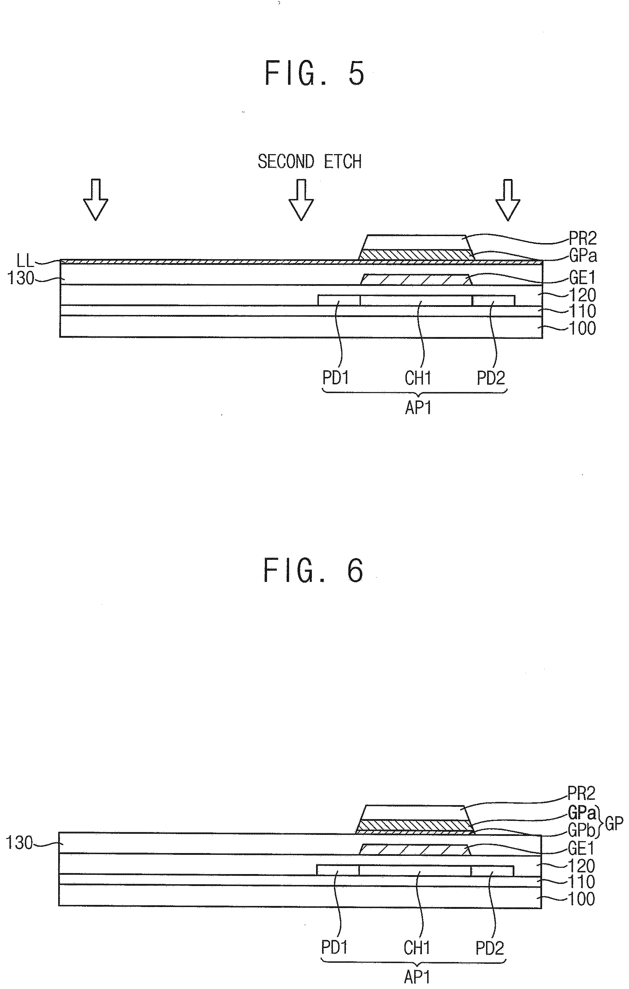

FIGS. 1 to 11 are cross-sectional views illustrating a method for manufacturing an organic light-emitting display device according to an exemplary embodiment.

Referring to FIG. 1, a semiconductor pattern 112 is formed on a base substrate 100.

The base substrate 100 may include glass, quartz, silicon, a polymer, or the like. For example, the polymer may include polyethylene terephthalate, polyethylene naphthalate, polyether ketone, polycarbonate, polyarylate, polyether sulfone, polyimide, or a combination thereof.

A buffer layer 110 may be disposed between the semiconductor pattern 112 and the base substrate 100. In this case, the semiconductor pattern 112 may be formed on the buffer layer 110. The buffer layer 110 may prevent or reduce penetration of impurities, humidity or external gas from underneath of the base substrate 100, and may planarize an upper surface of the base substrate 100. For example, the buffer layer 110 may include an inorganic material such as oxide, nitride, or the like. In an exemplary embodiment, the buffer layer 110 may have a multiple-layered structure including a lower layer including silicon nitride and an upper layer including silicon oxide.

In an exemplary embodiment, the semiconductor pattern 112 may include polycrystalline silicon (polysilicon). In order to form the semiconductor pattern 112, an amorphous silicon layer may be formed on the base substrate 100 and then crystallized to form a polysilicon layer.

For example, the amorphous silicon layer may be formed through sputtering, low-pressure chemical vapor deposition (LPCVD), plasma-enhanced chemical vapor deposition (PECVD), or the like. The amorphous silicon layer may be crystallized through excimer laser annealing (ELA), sequential lateral solidification (SLS), or the like.

For example, the polysilicon layer may be polished by chemical mechanical polishing (CMP) or the like to planarize a surface thereof. Thereafter, the polysilicon layer may be patterned by a photolithography or the like to form the semiconductor pattern. The semiconductor pattern may be doped with n-type impurities or p-type impurities.

Thereafter, a first insulation layer 120 is formed to cover the semiconductor pattern 112. The first insulation layer 120 may insulate a channel, which is formed from the semiconductor pattern 112, from a gate electrode formed on the first insulation layer 120.

For example, the first insulation layer 120 may include silicon oxide, silicon nitride, silicon carbide, or a combination thereof. Furthermore, the first insulation layer 120 may include an insulating metal oxide, such as aluminum oxide, tantalum oxide, hafnium oxide, zirconium oxide, titanium oxide or the like. The first insulation layer 120 may have a single-layered structure or a multiple-layered structure including silicon nitride and/or silicon oxide.

Referring to FIG. 2, a first gate metal layer is formed on the first insulation layer 120, and a first photoresist pattern PR1 is formed on the first gate metal layer.

The first gate metal layer may include metal, a metal alloy, a metal nitride, a conductive metal oxide, or the like. For example, the first gate metal layer may include gold (Au), silver (Ag), aluminum (Al), copper (Cu), nickel (Ni), platinum (Pt), magnesium (Mg), chromium (Cr), tungsten (W), molybdenum (Mo), titanium (Ti), tantalum (Ta) or an alloy thereof, and may have a single-layered structure or a multiple-layered structure including different metal layers.

The first photoresist layer pattern PR1 may partially overlap the semiconductor pattern 112. For example, a photoresist composition including a binder resin such as a phenol resin, an acryl resin, or the like may be coated, and may be exposed to light and developed to form the first photoresist pattern PR1.

Thereafter, the first gate metal layer is etched by using the first photoresist pattern PR1 as a mask to form a first gate electrode GE1. For example, the first gate metal layer may be etched by a dry etching method using plasma or the like. As the first gate electrode GE1 is formed, the first insulation layer 120 adjacent to the first gate electrode GE1 may be exposed.

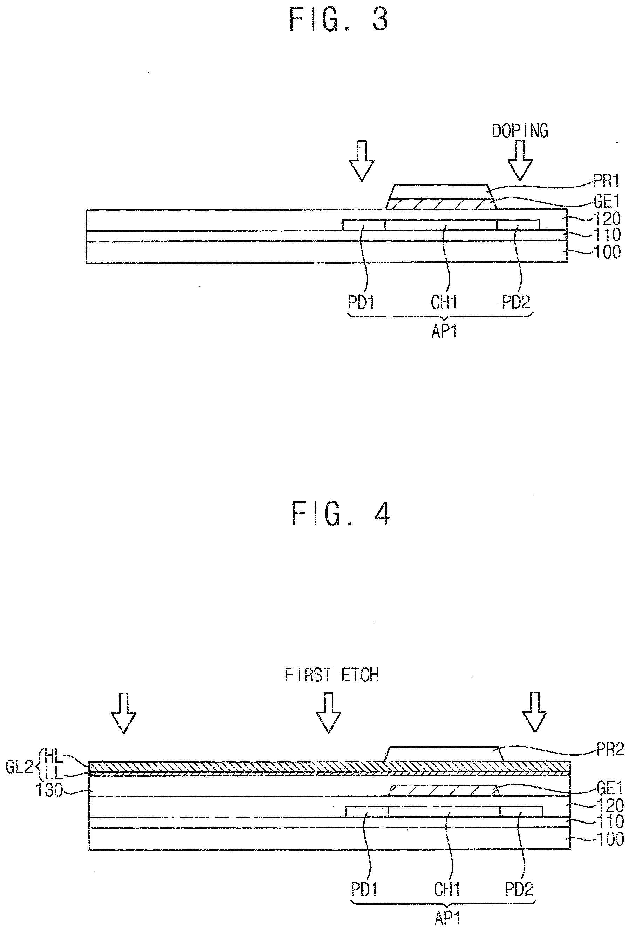

Referring to FIG. 3, impurities are provided to the exposed first insulation layer 120. For example, the impurities may include p-type impurities, such as boron or the like. In this manner, a peripheral portion of the semiconductor pattern 112, which does not overlap the first gate electrode GE1, is doped with p-type impurities to form a first doped area PD1 and a second doped area PD2. In the semiconductor pattern 112, a portion overlapping the first gate electrode GE1 may not be doped to define a channel area CH1.

As such, the first doped area PD1, the second doped area PD2, and the channel area CH1 may be disposed continuously on the same layer. The pattern including the first doped area PD1, the second doped area PD2, and the channel area CH1 may be define a first active pattern AP1.

The first photoresist pattern PR1 may be removed before or after the doping process.

Referring to FIG. 4, a second insulation layer 130 is formed to cover the first gate electrode GE1. A second gate metal layer GL2 is formed on the second insulation layer 130. A second photoresist pattern PR2 is formed on the second gate metal layer GL2.

For example, the second insulation layer 130 may include silicon oxide, silicon nitride, silicon carbide, or a combination thereof. Furthermore, the second insulation layer 130 may include an insulating metal oxide, such as aluminum oxide, tantalum oxide, hafnium oxide, zirconium oxide, titanium oxide or the like. For example, the second insulation layer 130 may include silicon nitride.

According to the invention, the second gate metal layer GL2 includes a lower layer LL and an upper layer HL disposed on the lower layer LL. The lower layer LL includes titanium or titanium alloy, and the upper layer HL includes molybdenum or molybdenum alloy. For example, the lower layer LL may include titanium, and the upper layer HL may include molybdenum.

A thickness of the upper layer HL may be greater than a thickness of the lower layer LL. In an exemplary embodiment, the thickness of the lower layer LL may be about 50Å (5nm) to about 300Å (30nm), and the thickness of the upper layer HL may be about 2,000Å (200nm) to about 2,500Å (250nm). In this manner, a preferable skew and taper angle may be obtained.

Referring to FIGS. 4 to 6, the upper layer HL is etched by using the second photoresist pattern PR2 as a mask.

In an exemplary embodiment, the upper layer HL including molybdenum may be etched by plasma of a first etching gas including a fluorine-containing compound. For example, the fluorine-containing compound may include SiF₄, CF₄, C₃F₈, C₂F₆, CHF₃, SF₆, or a combination thereof.

In an exemplary embodiment, the lower layer LL may be etched by plasma of a material different from the first etching gas. For example, a second etching gas for etching the lower layer LL may include a chlorine-containing compound. In an exemplary embodiment, the second etching gas may include a chlorine-containing compound and oxygen. For example, the lower layer LL may be etched by plasma of a mixture gas including CL₂ and O₂.

Accordingly, a gate wiring pattern GP may be formed on the second insulation layer 130. The gate wiring pattern GP may include a lower layer GPb including titanium or an alloy thereof, and an upper layer GPa including molybdenum or an alloy thereof.

The gate wiring pattern GP may include at least one of a data signal wiring providing a data signal, a gate signal wiring providing a gate signal, an initialization signal wiring providing an initialization signal, a light-emitting signal wiring providing a light-emitting signal, and a power voltage wiring providing a power voltage. In an exemplary embodiment, at least a portion of the gate wiring pattern GP may overlap the first gate electrode GE1 or the first active pattern AP1.

When the second gate metal layer GL2 is etched by the etching gas including the fluorine-containing compound, a fluorine ion generated from the etching gas may remain on a surface of the second insulation layer 130, or may be combined with an insulation material of the second insulation layer 130, for example, silicon nitride. When the fluorine ion diffuses into a third insulation layer 140 to be disposed on the second insulation layer 130, an oxide semiconductor element contacting the third insulation layer 140 may be deteriorated. In an exemplary embodiment, the second gate metal layer has a multiple-layered structure of molybdenum/titanium. As such, the lower layer contacting the second insulation layer 130 may be etched by materials other than the fluorine-containing compound. In this manner, fluorine ions may be substantially prevented from remaining on the surface of the second insulation layer 130 or being combined with the second insulation layer 130.

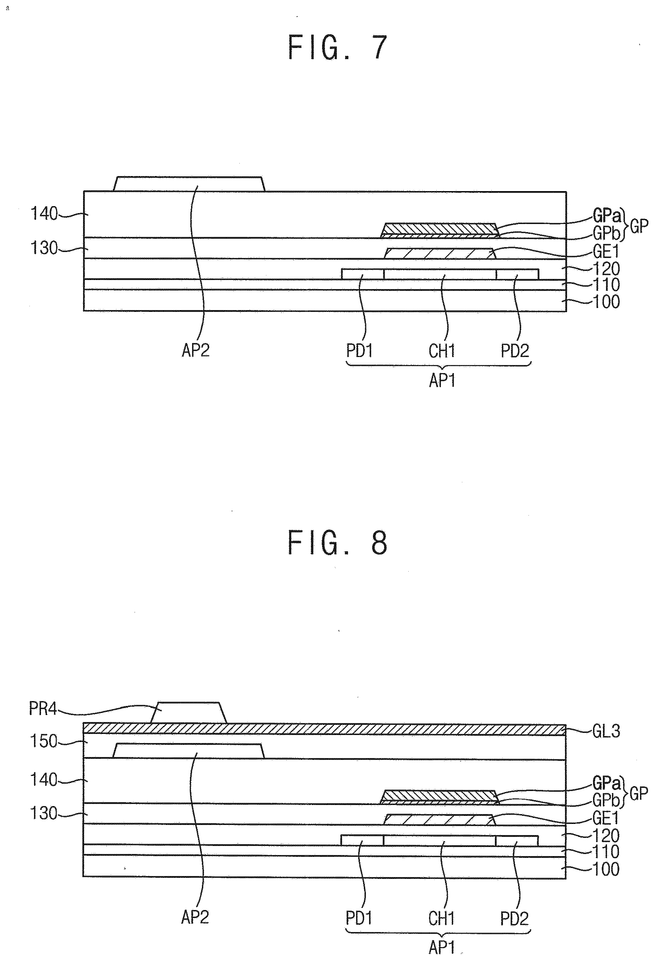

Referring to FIG. 7, the third insulation layer 140 is formed to cover the gate wiring pattern GP. A second active pattern AP2 is formed on the third insulation layer 140.

The third insulation layer 140 may include silicon oxide, silicon nitride, silicon carbide, or a combination thereof. Furthermore, the third insulation layer 140 may include an insulating metal oxide, such as aluminum oxide, tantalum oxide, hafnium oxide, zirconium oxide, titanium oxide or the like. For example, the third insulation layer 140 may include silicon oxide.

The second active pattern AP2 includes an oxide semiconductor. For example, the second active pattern AP2 may include two-component compound (ABₓ), ternary compound (ABₓC_{y}), or four-component compound (ABₓC_{y}D_{z}), which may include indium (In), zinc (Zn), gallium (Ga), tin (Sn), titanium (Ti), aluminum (Al), hafnium (Hf), zirconium (Zr), and magnesium (Mg). For example, the second active pattern AP2 may include zinc oxide (ZnOₓ), gallium oxide (GaOₓ), titanium oxide (TiOₓ), tin oxide (SnOₓ), indium oxide (InOₓ), indium-gallium oxide (IGO), indium-zinc oxide (IZO), indium tin oxide (ITO), gallium zinc oxide (GZO), zinc magnesium oxide (ZMO), zinc tin oxide (ZTO), zinc zirconium oxide (ZnZrₓO_{y}), indium-gallium-zinc oxide (IGZO), indium-zinc-tin oxide (IZTO), indium-gallium-hafnium oxide (IGHO), tin-aluminum-zinc oxide (TAZO), indium-gallium-tin oxide (IGTO), or the like.

Referring to FIG. 8, a preliminary insulation layer 150 is formed to cover the second active pattern AP2. A third gate metal layer GL3 is formed on the preliminary insulation layer 150. A fourth photoresist pattern PR4 is formed on the third gate metal layer GL3. The fourth photoresist pattern PR4 overlaps the second active pattern AP2.

The preliminary insulation layer 150 may include silicon oxide, silicon nitride, silicon carbide, or a combination thereof. Furthermore, the preliminary insulation layer 150 may include an insulating metal oxide, such as aluminum oxide, tantalum oxide, hafnium oxide, zirconium oxide, titanium oxide, or the like. For example, the preliminary insulation layer 150 may include silicon oxide.

The third gate metal layer GL₃ may include metal, a metal alloy, a metal nitride, a conductive metal oxide, or the like. For example, the third gate metal layer GL3 may include gold (Au), silver (Ag), aluminum (Al), copper (Cu), nickel (Ni), platinum (Pt), magnesium (Mg), chromium (Cr), tungsten (W), molybdenum (Mo), titanium (Ti), tantalum (Ta) ,or an alloy thereof, and may have a single-layered structure or a multiple-layered structure including different metal layers.

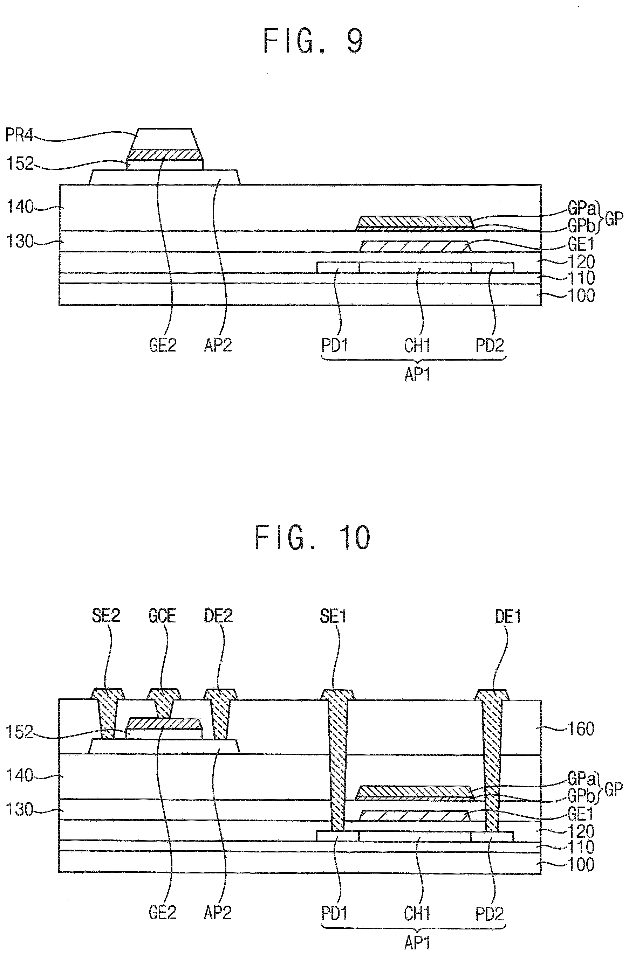

Referring to FIG. 9, the third gate metal layer GL3 is etched by using the fourth photoresist pattern PR4 as a mask to form a second gate electrode GE2. Thereafter, the preliminary insulation layer 150 is etched by using the second gate electrode GE2 as a mask to form a gate insulation pattern 152. In this manner, the gate insulation pattern 152 may have substantially the same shape as the second gate electrode GE2 in a plan view.

In the process of forming the gate insulation pattern 152 or by an additional process, a metallic element may be reduced to metal of the second active pattern AP2 in an exposed portion thereof to increase a conductivity of the second active pattern AP2. Thus, the exposed portion of the second active pattern AP2 may function as an ohmic contact.

Referring to FIG. 10, a fourth insulation layer 160 is formed to cover the second gate electrode GE2 and the second active pattern AP2. The fourth insulation layer 160 is patterned to form contact holes exposing the second gate electrode GE2, the second active pattern AP2, and the doped areas PD1and PD2 of the first active pattern AP1.

Thereafter, a first data metal layer is formed to fill the contact holes. The first data metal layer is patterned to form a first data metal pattern including a first source electrode SE1 contacting the first doped area PD1 of the first active pattern AP1, a first drain electrode DE1 contacting the second doped area PD2, a second source electrode SE2 contacting the second active pattern AP2, a second drain electrode DE2 contacting the second active pattern AP2 and spaced apart from the second source electrode SE2, and a gate connection electrode GCE contacting the second gate electrode GE2.

For example, the fourth insulation layer 160 may include silicon oxide, silicon nitride, silicon carbide, or a combination thereof. Furthermore, the fourth insulation layer 160 may include an insulating metal oxide, such as aluminum oxide, tantalum oxide, hafnium oxide, zirconium oxide, titanium oxide or the like. For example, the fourth insulation layer 160 may have a multiple-layered structure including a lower layer including silicon oxide and an upper layer including silicon nitride.

The first data metal layer may include metal, a metal alloy, a metal nitride, a conductive metal oxide, or the like. For example, the first data metal layer may include gold (Au), silver (Ag), aluminum (Al), copper (Cu), nickel (Ni), platinum (Pt), magnesium (Mg), chromium (Cr), tungsten (W), molybdenum (Mo), titanium (Ti), tantalum (Ta) or an alloy thereof, and may have a single-layered structure or a multiple-layered structure including different metal layers.

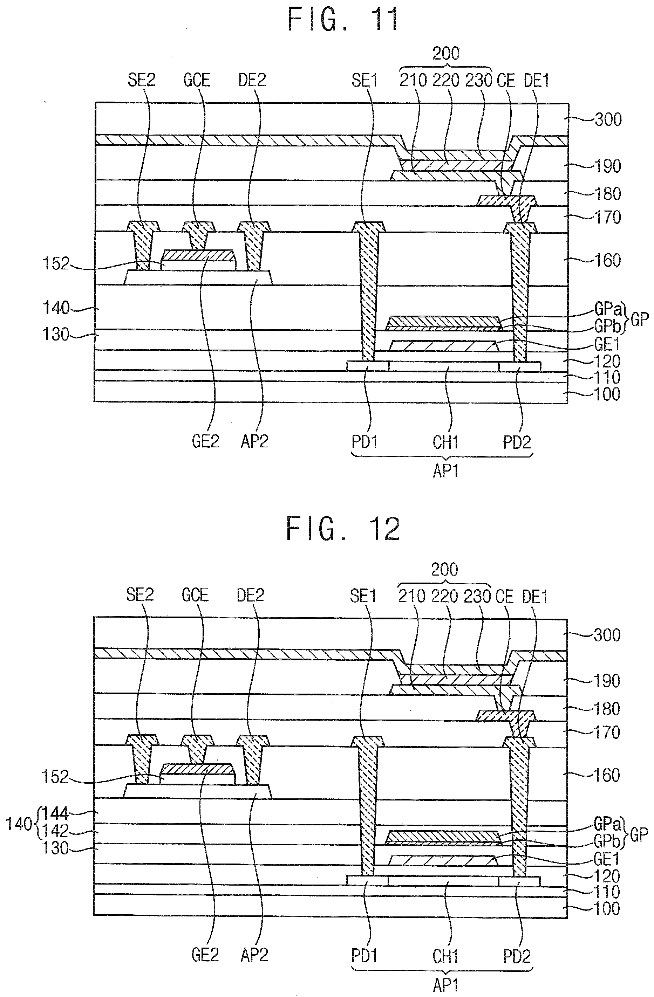

Referring to FIG. 11, a fifth insulation layer 170 is formed to cover the first data metal pattern. The fifth insulation layer 170 is patterned to form a contact hole exposing the first drain electrode DE1. Thereafter, a second data metal layer is formed to fill the contact hole, and then patterned to form a connection electrode CE contacting the first drain electrode DE1.

Thereafter, a sixth insulation layer 180 is formed to cover the connection electrode CE. The sixth insulation layer 180 is patterned to form a contact hole exposing the connection electrode CE. Thereafter, a lower electrode layer is formed to fill the contact hole, and then patterned to form a lower electrode 210 of an organic light-emitting diode 200.

For example, the fifth insulation layer 170 and the sixth insulation layer 180 may include an organic insulation material, such as a phenol resin, an acryl resin, a polyimide resin, a polyamide resin, a siloxane resin, an epoxy resin, or the like. The fifth insulation layer 170 and the sixth insulation layer 180 may have a flat upper surface to planarize an upper surface of the substrate.

In an exemplary embodiment, the lower electrode 210 may function as an anode. For example, the lower electrode 210 may be formed as a transmitting electrode or a reflecting electrode according to an emission type of the display device. When the lower electrode 210 is a transmitting electrode, the lower electrode 210 may include indium tin oxide, indium zinc oxide, zinc tin oxide, indium oxide, zinc oxide, tin oxide, or the like. When the lower electrode 210 is a reflecting electrode, the lower electrode 210 may include gold (Au), silver (Ag), aluminum (Al), copper (Cu), nickel (Ni), platinum (Pt), magnesium (Mg), chromium (Cr), tungsten (W), molybdenum (Mo), titanium (Ti) or a combination thereof, and may have a stack structure further including a material that may be used for the transmitting electrode.

A pixel-defining layer 190 may be disposed on the sixth insulation layer 180. The pixel-defining layer 190 may include an opening that exposes at least a portion of the lower electrode 210. For example, the pixel-defining layer 190 may include an organic insulation material.

An light-emitting layer 220 is formed on the lower electrode 210. The light-emitting layer 220 may include at least one of a hole injection layer (HIL), a hole transporting layer (HTL), an organic light-emitting layer, an electron transporting layer (ETL), and an electron injection layer (EIL). For example, the light-emitting layer 220 may include a low molecular weight organic compound or a high molecular weight organic compound.

In an exemplary embodiment, the light-emitting layer 220 may emit a red light, a green light, or a blue light. In another exemplary embodiment, the light-emitting layer 220 may emit a white light. The light-emitting layer 220 emitting a white light may have a multiple-layer structure including a red-emitting layer, a green-emitting layer, and a blue-emitting layer, or a single-layer structure including a mixture of a red-emitting material, a green-emitting material, and a blue-emitting material.

The light-emitting layer 220 may be formed by a screen printing method, an inkjet printing method, a deposition method, or the like.

An upper electrode 230 is formed on the light-emitting layer 220. In an exemplary embodiment, the upper electrode 230 may function as a cathode. For example, the upper electrode 230 may be formed as a transmitting electrode or a reflecting electrode according to an emission type of the display device. For example, when the upper electrode 230 is a transmitting electrode, the upper electrode 230 may include lithium (Li), calcium (Ca), lithium fluoride (LiF), aluminum (Al), magnesium (Mg), or a combination thereof.

The upper electrode 230 may extend continuously across a plurality of pixels in a display area. In an exemplary embodiment, a capping layer and a blocking layer may be formed on the upper electrode 230.

In an exemplary embodiment, an encapsulation layer 300 may be formed on the organic light-emitting diode 200. The encapsulation layer 300 may have a stack structure of an inorganic layer and an organic layer. For example, the organic layer may include a cured resin such as poly(meth)acrylate or the like. For example, the inorganic layer may include silicon oxide, silicon nitride, silicon carbide, aluminum oxide, tantalum oxide, hafnium oxide, zirconium oxide, titanium oxide, or the like.

In an exemplary embodiment, the organic light-emitting display device may have a front-emission type, in which light exits through the upper electrode 230. However, the inventive concepts are not limited thereto. For example, the organic light-emitting display device may have a rear-emission type, in which light exits in an opposing direction.

The organic light-emitting display device includes an oxide-based semiconductor element and a silicon-based semiconductor element. In an exemplary embodiment, the silicon-based semiconductor element may function as a driving transistor providing current to the organic light-emitting diode 200.

In an exemplary embodiment, the silicon-based semiconductor element may include the first active pattern AP1, the first gate electrode GE1, the first source electrode SE1, and the first drain electrode DE1.

For example, the first active pattern AP1 includes the channel area CH1, the first doped area PD1, and the second doped area PD2. The first gate electrode GE1 may be disposed on the first active pattern AP1 and may overlap the first channel area CH1. The first source electrode SE1 may contact the first doped area PD1, and the first drain electrode DE1 may contact the second doped area PD2.

In an exemplary embodiment, the oxide-based semiconductor element may function as a switching transistor to control the driving transistor. For example, the drain electrode of the oxide-based semiconductor element may be electrically connected to the gate electrode of the silicon-based semiconductor element.

In an exemplary embodiment, the oxide-based semiconductor element may have a top-gate configuration. For example, the oxide-based semiconductor element may include the second gate electrode GE2, the second active pattern AP2 disposed under the second gate electrode GE2, the second source electrode SE2, and the second drain electrode DE2.

FIG. 12 is a cross-sectional view of an organic light-emitting display device according to an exemplary embodiment.

The organic light-emitting display device illustrated in FIG. 12 has substantially the same configuration as the organic light-emitting display device illustrated in FIG. 10, except for a third insulation layer 140 disposed under a second active pattern AP2.

Referring to FIG. 12, the third insulation layer 140 covers a gate wiring pattern GP and a second insulation layer 130. A second active pattern AP2 including an oxide semiconductor is disposed on the third insulation layer 140.

The third insulation layer 140 may include a lower barrier layer 142 contacting the second insulation layer 130 and the gate wiring pattern GP, and an upper barrier layer 144 disposed on the lower barrier layer 142.

In an exemplary embodiment, the lower barrier layer 142 may include silicon nitride. Thus, the lower barrier layer 142 may prevent fluorine ions remaining at the second insulation layer 120 from diffusing upwardly.

In an exemplary embodiment, the upper barrier layer 144 may include silicon oxide. Thus, the upper barrier layer 144 may prevent hydrogen ions of the lower barrier layer 142 from diffusing upwardly.

In this manner, the third insulation layer 140 may prevent characteristics of the second active pattern AP2 disposed on the third insulation layer 140 from being deteriorated by hydrogen ions or fluorine ions.

In an exemplary embodiment, a thickness of the upper barrier layer 144 may be greater than a thickness of the lower barrier layer 142. For example, the thickness of the lower barrier layer 142 may be about 200Å (20nm) to about 1,000Å (100nm), and the thickness of the upper barrier layer 144 may be about 1,000Å (100nm) to about 3,000Å (300nm). When the upper barrier layer 144 and the lower barrier layer 142 are too thin, the barrier abilities thereof may be deteriorated.

FIG. 12 shows that the third insulation layer 140 has a double-layered structure. However, the inventive concepts are not limited thereto. For example, in another exemplary embodiment, the third insulation layer 140 may include at least three layers, including a lower barrier layer including silicon nitride and an upper barrier layer including silicon oxide.

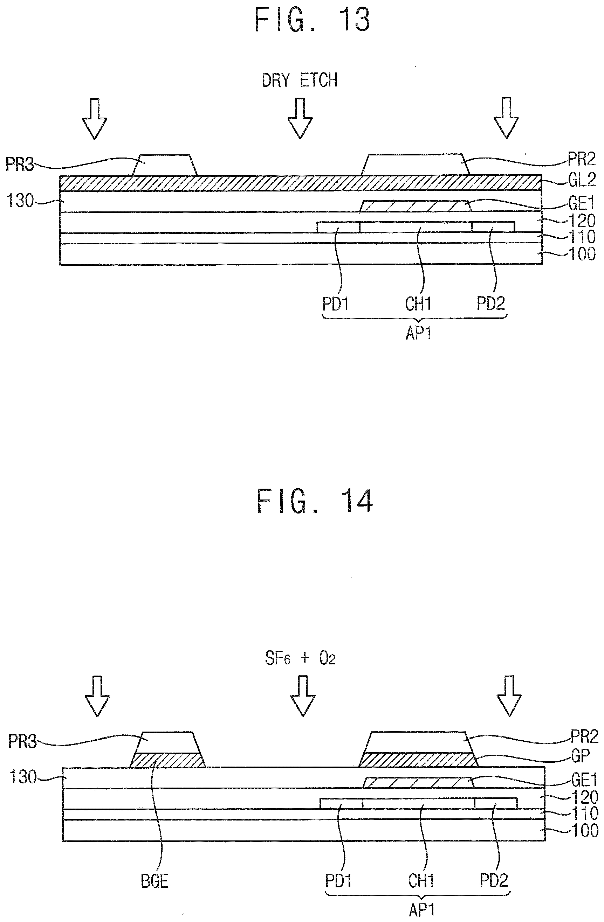

FIGS. 13 to 16 are cross-sectional views illustrating a method for manufacturing an organic light-emitting display device according to an exemplary embodiment.

Referring to FIG. 13, a buffer layer 110 is formed on a base substrate 100.

A semiconductor pattern is formed on the buffer layer 110. A first insulation layer 120 is formed to cover the semiconductor pattern. A first gate electrode GE1 is formed on the first insulation layer 120. The semiconductor pattern is partially doped to form a first active pattern AP1 including a first doped area PD1, a second doped area PD2 spaced apart from the first doped area PD₁, and a channel area CH₁ disposed between the first doped area PD1 and the second doped area PD2. A second insulation layer 130 is formed to cover the first gate electrode GE1.

Methods for forming the buffer layer 110, the first active pattern AP1, the first insulation layer 120, the first gate electrode GE1, and the second insulation layer 130 are substantially the same as those illustrated with reference to FIGS.1 to 4, and thus, repeated descriptions thereof will be omitted to avoid redundancy.

Thereafter, a second gate metal layer GL₂ is formed on the second insulation layer 130. A second photoresist pattern PR2 and a third photoresist pattern PR3 are formed on the second gate metal layer GL2. In an exemplary embodiment, the second photoresist pattern PR2 may overlap the first gate electrode GE1.

The second gate metal layer GL2 may include metal, a metal alloy, a metal nitride, a conductive metal oxide or the like. For example, the second gate metal layer GL2 may include gold (Au), silver (Ag), aluminum (Al), copper (Cu), nickel (Ni), platinum (Pt), magnesium (Mg), chromium (Cr), tungsten (W), molybdenum (Mo), titanium (Ti), tantalum (Ta) or an alloy thereof, and may have a single-layered structure or a multiple-layered structure including different metal layers. In an exemplary embodiment, the second gate metal layer GL₂ may include molybdenum or an alloy thereof.

Referring to FIGS. 13 and 14, the second gate metal layer GL2 is patterned by using the second photoresist pattern PR2 and the third photoresist pattern PR3 as a mask. In this manner, a gate metal pattern including a gate wiring pattern GP disposed under the second photoresist pattern RP2 and a bottom gate electrode BGE disposed under the third photoresist pattern PR3 may be formed.

The second gate metal layer GL2 may be patterned by a dry-etching process. For example, plasma of a fluorine-containing compound may be provided to the second gate metal layer GL2 for the dry-etching process. For example, the fluorine-containing compound may include SiF₄, CF₄, C₃F₈, C₂F₆, CHF₃, SF₆, or a combination thereof.

When the second gate metal layer GL2 is etched by an etching gas including the fluorine-containing compound, fluorine ions generated from the etching gas may remain on a surface of the second insulation layer 130, or may be combined with an insulation material of the second insulation layer 130, for example, silicon nitride. In an exemplary embodiment, a post-treatment may be performed to remove the fluorine ions.

For example, as illustrated in FIG. 14, plasma of a treatment gas including SF₆ and O₂ may be provided to the second insulation layer 130. The surface treatment may remove fluorine ions remaining on the second insulation layer 130 or remove silicon nitride combined with fluorine. As such, diffusion of fluorine ions may be prevented, which may improve reliability of the organic light-emitting display device.

The surface treatment may be performed after or before removing the second photoresist pattern PR2 and the third photoresist pattern PR3.

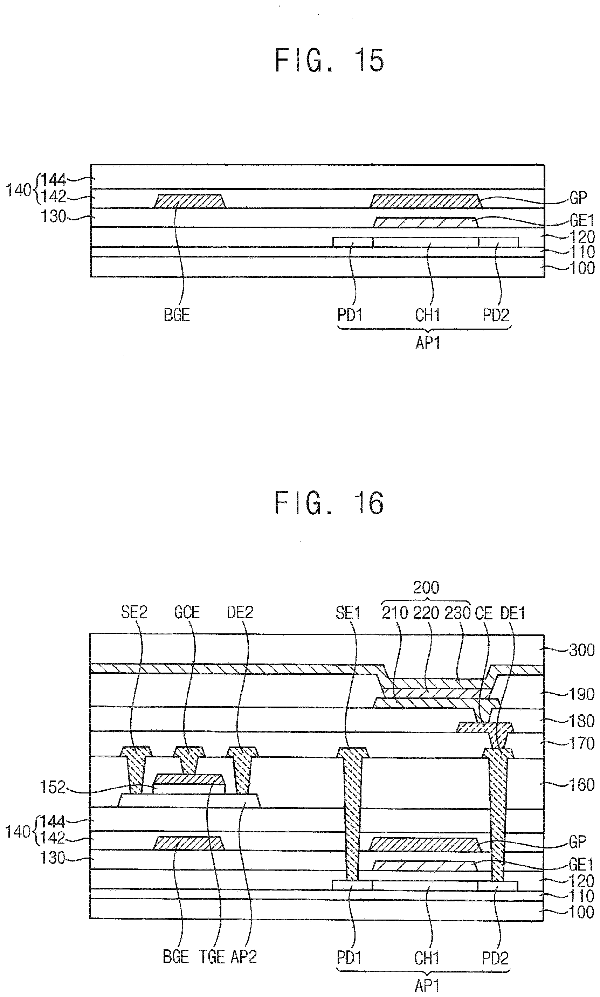

Referring to FIG. 15, a third insulation layer 140 is formed to cover the bottom gate electrode BGE and the gate wiring pattern GP.

The third insulation layer 140 may include a lower barrier layer 142 contacting the second insulation layer 130 and the bottom gate electrode BGE, and an upper barrier layer 144 disposed on the lower barrier layer 142. In an exemplary embodiment, the lower barrier layer 142 may include silicon nitride, and the upper barrier layer 144 may include silicon oxide. Thus, fluorine ions remaining at the second insulation layer 120 may be prevented from diffusing upwardly, and hydrogen ions of the lower barrier layer 142 may be prevented from diffusing upwardly.

Referring to FIG. 16, a second active pattern AP2 is formed on the third insulation layer 140. A preliminary insulation layer and a third gate metal layer are formed on the second active pattern AP2, and then are patterned to form a top gate electrode TGE disposed on the second active pattern AP2, and a gate insulation pattern 152 disposed between the top gate electrode TGE and the second active pattern AP2.

A fourth insulation layer 160 is formed to cover the top gate electrode TGE, the second active pattern AP2, and the third insulation layer 140.

Thereafter, a first data metal pattern, which includes a first source electrode SE1, a first drain electrode DE1, a second source electrode SE2, a second drain electrode DE2, and a gate connection electrode GCE, is formed. The first source electrode SE1 contacts the first doped area PD1 of the first active pattern AP1. The first drain electrode DE1 contacts the second doped area PD2 of the first active pattern AP1. The second source electrode SE2 and the second drain electrode DE2 contact the second active pattern AP2. The second drain electrode DE2 is spaced apart from the second source electrode SE2. The gate connection electrode GCE contacts the second gate electrode GE2.

Thereafter, a fifth insulation layer 170 is formed to cover the first data metal pattern. A connection electrode CE is formed to pass through the fifth insulation layer 170 thereby contacting the first drain electrode DE1. A sixth insulation layer 180 is formed to cover the connection electrode CE.

Thereafter, an organic light-emitting diode 200, a pixel-defining layer 190, and an encapsulation layer 300 are formed. The organic light-emitting diode 200 includes a lower electrode 210, a light-emitting layer 220, and an upper electrode 230.

According to an exemplary embodiment, an organic light-emitting display device includes an oxide-based semiconductor element and a silicon-based semiconductor element, and has a double-gate structure in which a top gate electrode and a bottom gate electrode are respectively disposed on and under the active pattern of the oxide-based semiconductor element. In this manner, reliability of the oxide-based semiconductor element may be improved, and the oxide-based semiconductor element may be controlled more precisely.

Furthermore, as the third insulation layer 140, which includes the lower barrier layer 142 including silicon nitride, and the upper barrier layer 144 including silicon oxide to function as a barrier insulation layer, is disposed between the bottom gate electrode BGE and the second active pattern AP2, diffusion of fluorine ions from the bottom gate electrode BGE and an insulation layer thereunder may be prevented. Thus, the reliability of the oxide-based semiconductor element may be improved.

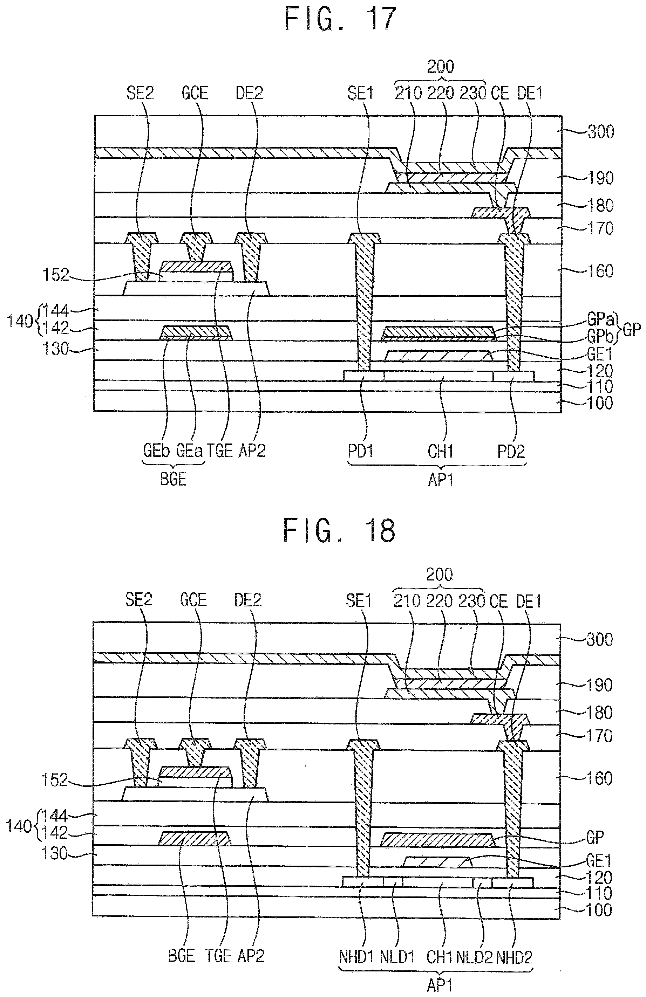

FIG. 17 is a cross-sectional view illustrating an organic light-emitting display device fabricated in accordance with the claimed invention.

Referring to FIG. 17, the organic light-emitting display device according to an exemplary embodiment is substantially the same as the organic light-emitting display device illustrated in FIG. 16, except for a bottom gate electrode BGE and a gate wiring pattern GP, which have a double-layered structure.

More particularly, a bottom gate electrode BGE and a gate wiring pattern GP are disposed on a second insulation layer 130.

The bottom gate electrode BGE includes a lower layer GEb including titanium or titanium alloy, and an upper layer GEa including molybdenum or molybdenum alloy. The gate wiring pattern GP includes a lower layer GPb including titanium or titanium alloy, and an upper layer GPa including molybdenum or molybdenum alloy.

In an exemplary embodiment, the bottom gate electrode BGE and the gate wiring pattern GP may be formed from a second gate metal layer including a lower layer including titanium or titanium alloy, and an upper layer including molybdenum or molybdenum alloy.

According to the claimed invention, the upper layer is etched by plasma of a fluorine-containing compound, and the lower layer is etched by plasma of a material different from the fluorine-containing compound.

Thus, the lower layer contacting the second insulation layer 130 may be etched by material other than the fluorine-containing compound. In this manner, fluorine ions remaining on the second insulation layer 130 or combined with the second insulation layer 130 may be substantially reduced.

Furthermore, a third insulation layer 140, which includes a lower barrier layer 142 including silicon nitride, and an upper barrier layer 144 including silicon oxide to function as a barrier insulation layer, is disposed on the bottom gate electrode BGE and the gate wiring pattern GP. Thus, diffusion of fluorine ions from the bottom gate electrode BGE may be prevented.

FIG. 18 is a cross-sectional view illustrating an organic light-emitting display device according to an exemplary embodiment.

Referring to FIG. 18, the organic light-emitting display device according to an exemplary embodiment is substantially the same as the organic light-emitting display device illustrated in FIG. 16, except for a first active pattern.

For example, a silicon-based semiconductor element of the organic light-emitting display device may have an NMOS configuration as illustrated in FIG. 18. For example, a first active pattern AP1 of a driving transistor may include a channel area CH1, a first high-doped area NHD1, a first low-doped area NLD1, a second low-doped area NLD2, and a second high-doped area NHD2.

The first high-doped area NHD1 and the second high-doped area NHD2 may be doped with n-type impurities, such as phosphor, arsenic, or the like with a high concentration. The first low-doped area NLD1 and the second low-doped area NLD2 may be doped with n-type impurities with a low concentration.

The channel area CH1 may be defined by a portion of the first active pattern AP1, which is not doped.

The first low-doped area NLD1 may be disposed between the first high-doped area NHD1 and the channel area CH1, and the second low-doped area NLD2 may be disposed between the second high-doped area NHD2 and the channel area CH1.

The first high-doped area NHD1 may be connected to a first source electrode SE1, and the second high-doped area NHD2 may be connected to a first drain electrode DE1.

The first active pattern AP1 having the NMOS configuration may be applied to the organic light-emitting display devices illustrated in FIGS. 11, 12 and 17.

Exemplary embodiments may be applied to various display devices. For example, exemplary embodiment may be applied to vehicle-display device, a ship-display device, an aircraft-display device, portable communication devices, display devices for display or for information transfer, a medical-display device, etc.

According to exemplary embodiments, a gate metal patter including a bottom gate electrode or a gate wiring pattern has a multiple-layered structure including molybdenum/titanium. Thus, diffusion of fluorine ions into an insulation layer disposed on the gate metal pattern may be prevented.

Furthermore, a barrier insulation layer is disposed on the gate metal pattern, and the barrier insulation layer includes a lower barrier layer including silicon nitride, and an upper barrier layer disposed on the lower barrier layer and including silicon oxide. Thus, fluorine ions diffusing from the gate metal pattern and an insulation layer disposed under the gate metal pattern may be blocked.

Furthermore, after the gate metal pattern is formed, fluorine ions may be removed from the insulation layer disposed under the gate metal pattern by using plasma of a treatment gas.

Thus, reliability of an oxide-based semiconductor element may be improved.

Although certain exemplary embodiments and implementations have been described herein, other embodiments and modifications will be apparent from this description. Accordingly, the inventive concepts are not limited to such embodiments, but rather to the broader scope of the appended claims.

## Claims

1. A method for manufacturing a display device, the method comprising:
forming a first active pattern (AP1) comprising a silicon semiconductor;
forming a first gate electrode (GE1) on the first active pattern (AP1);
forming a second insulation layer (130) to cover the first gate electrode (GE1);
forming a metal layer (GL2) on the second insulation layer (130), the metal layer (GL2) including a lower layer (LL) comprising titanium or titanium alloy, and an upper layer (HL) comprising molybdenum or molybdenum alloy;
etching the upper layer (HL) by using a first etching gas comprising fluorine;
etching the lower layer (LL) by using a second etching gas that does not comprise fluorine to form a gate metal pattern including a bottom gate electrode;
forming a third insulation layer (140) on the gate metal pattern; and
forming a second active pattern (AP2) comprising an oxide semiconductor and overlapping the bottom gate electrode on the third insulation layer (140).

2. The method of claim 1, wherein the first etching gas includes at least one of SiF₄, CF₄, C₃F₈, C₂F₆, CHF₃, and SF₆.

3. The method of claim 1 or 2, wherein the second etching gas comprises chlorine and oxygen, optionally wherein the second etching gas comprises Cl₂ and O₂.

4. The method of claim 1, 2 or 3, wherein the third insulation layer includes a lower barrier layer (142) comprising silicon nitride, and an upper barrier layer (144) disposed on the lower barrier layer and comprising silicon oxide.

5. The method of any one of claims 1 to 4, further comprising forming a top gate electrode (TGE) on the second active pattern.

## Patentansprüche

1. Verfahren zur Herstellung einer Anzeigevorrichtung, wobei das Verfahren Folgendes umfasst:
Bilden eines ersten aktiven Musters (AP1), das einen Siliziumhalbleiter umfasst;
Bilden einer ersten Gate-Elektrode (GE1) auf dem ersten aktiven Muster (AP1);
Bilden einer zweiten Isolierschicht (130), um die erste Gate-Elektrode (GE1) zu bedecken;
Bilden einer Metallschicht (GL2) auf der zweiten Isolierschicht (130), wobei die Metallschicht (GL2) eine untere Schicht (LL), die Titan oder eine Titanlegierung umfasst, und eine obere Schicht (HL), die Molybdän oder eine Molybdänlegierung umfasst, beinhaltet;
Ätzen der oberen Schicht (HL) durch Verwendung eines ersten Ätzgases, das Fluor umfasst;
Ätzen der unteren Schicht (LL) durch Verwendung eines zweiten Ätzgases, das kein Fluor umfasst, um ein Gate-Metallmuster zu bilden, das eine untere Gate-Elektrode beinhaltet;
Bilden einer dritten Isolierschicht (140) auf dem Gate-Metallmuster; und
Bilden eines zweiten aktiven Musters (AP2), das einen Oxidhalbleiter umfasst und die untere Gate-Elektrode auf der dritten Isolierschicht (140) überlappt.

2. Verfahren nach Anspruch 1, wobei das erste Ätzgas mindestens eines von SiF₄, CF₄, C₃F₈, C₂F₆, CHF₃ und SF₆ beinhaltet.

3. Verfahren nach Anspruch 1 oder 2, wobei das zweite Ätzgas Chlor und Sauerstoff umfasst, wobei das zweite Ätzgas optional Cl₂ und O₂ umfasst.

4. Verfahren nach Anspruch 1, 2 oder 3, wobei die dritte Isolierschicht eine untere Barriereschicht (142), die Siliziumnitrid umfasst, und eine obere Barriereschicht (144), die auf der unteren Barriereschicht angeordnet ist und Siliziumoxid umfasst, beinhaltet.

5. Verfahren nach einem der Ansprüche 1 bis 4, ferner umfassend das Bilden einer oberen Gate-Elektrode (TGE) auf dem zweiten aktiven Muster.

## Revendications

1. Procédé permettant la fabrication d'un afficheur, le procédé comprenant :
la formation d'un premier motif actif (AP1) comprenant un semi-conducteur en silicium ;
la formation d'une première électrode de grille (GE1) sur le premier motif actif (AP1) ;
la formation d'une deuxième couche d'isolation (130) pour recouvrir la première électrode de grille (GE1) ;
la formation d'une couche métallique (GL2) sur la deuxième couche d'isolation (130), la couche métallique (GL2) comprenant une couche inférieure (LL) comprenant du titane ou un alliage de titane, et une couche supérieure (HL) comprenant du molybdène ou un alliage de molybdène ;
la gravure chimique de la couche supérieure (HL) à l'aide d'un premier gaz de gravure chimique comprenant du fluor ;
la gravure chimique de la couche inférieure (LL) à l'aide d'un second gaz de gravure chimique qui ne comprend pas de fluor pour former un motif de métal de grille comprenant une électrode de grille inférieure ;
la formation d'une troisième couche d'isolation (140) sur le motif métallique de grille ; et
la formation d'un second motif actif (AP2) comprenant un semi-conducteur oxyde et chevauchant l'électrode de grille inférieure sur la troisième couche d'isolation (140).

2. Procédé de la revendication 1, ledit premier gaz de gravure chimique comprenant au moins l'un de SiF₄, CF₄, C₃F₈, C₂F₆, CHF₃ et SF₆.

3. Procédé de la revendication 1 ou 2, ledit second gaz de gravure chimique comprenant du chlore et de l'oxygène, éventuellement ledit second gaz de gravure chimique comprenant du Cl₂ et O₂.

4. Procédé de la revendication 1, 2 ou 3, ladite troisième couche d'isolation comprenant une couche barrière inférieure (142) comprenant du nitrure de silicium, et une couche barrière supérieure (144) disposée sur la couche barrière inférieure et comprenant de l'oxyde de silicium.

5. Procédé de l'une quelconque des revendications 1 à 4, comprenant en outre une électrode de grille supérieure (TGE) sur le second motif actif.
